Europäisches Patentamt

European Patent Office

Office européen des brevets

(11) Veröffentlichungsnummer: **0 268 781**
**A1**

# (12) EUROPÄISCHE PATENTANMELDUNG

(21) Anmeldenummer: 87114275.8

(22) Anmeldetag: 30.09.87

(51) Int. Cl.⁴: **H05K 3/46** , H05K 3/18

(30) Priorität: 30.09.86 DE 3633258

(43) Veröffentlichungstag der Anmeldung:
**01.06.88 Patentblatt 88/22**

(84) Benannte Vertragsstaaten:
**ES GR**

(71) Anmelder: **Wilde Membran Impuls Technik GmbH**
**Pregelstrasse 2**
**D-5828 Ennepetal(DE)**

(72) Erfinder: **Wilde, Horst Dieter**
**Pregelstrasse 2A**
**D-5828 Ennepetal(DE)**
Erfinder: **Bonack, Armin**
**Junkerstrasse 10**
**D-5650 Solingen(DE)**

(74) Vertreter: **Patentanwaltsbüro Cohausz & Florack**
**Postfach 14 01 47**
**D-4000 Düsseldorf 1(DE)**

(54) **Additiv metallisierte elektrisch leitfähige Struktur.**

(57) Die Erfindung bezieht sich auf einlagige und mehrlagige gedruckte Strukturen und ein Verfahren zum Herstellen dieser Strukturen. Solche Strukturen lassen sich sehr genau mit geringster Dicke und Breite durch additives Metallisieren nach dem erfindungsgemäßen Verfahren herstellen. Bei der Metallisierung wächst das abzuscheidende Metall nicht über den Bereich der aufgedruckten, einen Aktivator enthaltenden Substanz.

Fig.1

EP 0 268 781 A1

## Additiv metallisierte elektrisch leitfähige Struktur

Gedruckte elektrische Strukturen, z.B. Schaltungen, lassen sich auf verschiedene Art und Weise herstellen. In der Praxis haben sich Leiterplatten bewährt, bei denen die elektrisch leitfähigen Strukturen (z.B. Leiterbilder) aus einer auf einem Träger aufgebrachten Metallfolie durch Wegätzen von Teilen der Metallfolie gebildet werden. Eine solche Leiterplatte hat wegen der aus reinem Metall bestehenden Leiterbahnen den Vorteil eines geringen Leitungswiderstandes. Nachteilig ist der große Herstellungsaufwand.

Mit wesentlich geringerem Herstellungsaufwand und höherer Präzision lassen sich gedruckte elektrische Schaltungen nach einem anderen Verfahren herstellen, das auch für mehrlagige elektrische Schaltungen (Multilayer) geeignet ist. Bei diesem Verfahren werden die elektrisch leitfähigen Strukturen durch Aufdrucken einer leitfähigen Paste, z.B. einer Silberpaste, insbesondere im Siebdruck auf einem isolierenden Träger hergestellt. Der Nachteil bei solchen gedruckten Schaltungen besteht darin, daß wegen des in der Paste enthaltenen Bindemittels und der Größe der Silberpartikel die Leitfähigkeit der Paste nicht besonders gut ist. Deshalb ist es üblich, verhältnismäßig dicke Leiterbahnen (8 - 12 μm) aufzudrucken. Hinzu kommt, daß bei Verwendung einer Silberpaste das Silber zwischen benachbarten Leiterbahnen unterschiedlichen Potentials bei Einwirkung von Feuchtigkeit migriert und zu Kriechströmen und sogar Kurzschlüssen führt. Deshalb ist es erforderlich, die Leiterbahnen durch besondere Schutzfilme zu - schützen. Ein weiterer Nachteil besteht darin, daß sich auf die Leiterbahnen keine Bauteile auflöten lassen (DE-A1 34 13 408).

Schließlich ist ein Verfahren zur Herstellung von gedruckten elektrischen Schaltungen bekannt, bei dem auf einem isolierenden Träger eine einen Aktivator enthaltende Formulierung (pastöse Substanz) entsprechend der gewünschten Struktur aufgedruckt wird und anschließend auf dem mit dieser Formulierung bedruckten Teil der Oberfläche des isolierenden Trägers in einem Metallisierungsbad Metall abgeschieden wird. In diesem Fall werden rein metallische Strukturen geringer Dicke erreicht. Trotz dieses Vorteils konnte sich dieses seit mehreren Jahrzehnten bekannte Verfahren in der Praxis gegenüber den beiden anderen Verfahren nicht durchsetzen (DE-PS 11 76 731).

Ein Verfahren zum Herstellen von elektrisch leitenden Strukturen, bei dem eine Substanz, die aus organometallischen Aktivatoren, organischen Lösungsmitteln, Füllstoffen und Bindemitteln besteht, eingesetzt wird, ist aus der DE 32 41 579 bekannt. Ferner sind Verfahren zur Herstellung gedruckter Schaltungen in der DE - 26 35 457 und DE - 27 37 582 beschrieben. Die DE-PS 34 13 408, DE-PS 30 06 117, DE-OS 25 58 367 und DE-PS 30 32 931 beschreiben darüber hinaus Verfahren zum Herstellen von mehrlagigen gedruckten Schaltungen.

Trotz der aufgezeigten Nachteile von im Siebdruck unter Verwendung von einer elektrisch leitenden Metallpaste, insbesondere Silberpaste, gedruckten elektrischen Schaltungen hat dieses Verfahren sich für viele Anwendungen, wo hohe Anforderungen an die Genauigkeit des Leiterbildes gestellt sind, bewährt. Im Zuge der technischen Entwicklung steigen jedoch die Anforderungen an die Genauigkeit. Gefordert werden gedruckte elektrisch leitende Strukturen höchster Präzision bei möglichst geringer Dicke der Metallschicht. Eine Schwierigkeit, diese Anforderungen zu erfüllen, besteht vor allem darin, schmale Strukturen ausreichend dauerhaft und fest mit dem Träger zu verbinden.

Diese Forderung konnte bisher weder durch Aufdrucken einer elektrisch leitfähigen Metallpaste (DE-PS 34 13 408 A 1) noch durch stromlose Metallabscheidung (DE-PS 11 76 731) optimal erfüllt werden.

Gegenstand der Erfindung ist daher eine elektrisch leitende Struktur, die aus einem Träger mit insbesondere isolierender Oberfläche und einer auf der Oberfläche mit einer einen Aktivator enthaltenden, aufgedruckten Substanz stromlos aus einem Metallisierungsbad abgeschiedenen Metallschicht besteht, wobei die Substanz organometallische Aktivatoren, Füllstoffe, organische Lösungsmittel und Bindemittel enthält.

Als Bindemittel kommen in Betracht: ein Copolymerisat aus

a) 5 bis 80 Gew.-% eines cyangruppenhaltigen Monomeren,

b) 5 bis 40 Gew.-% gegebenenfalls kernsubstituiertes (Methyl)Styrol und/oder

c) 5 bis 40 Gew.-% (Methy)Acrylsäureester und/oder

d) 5 bis 40 Gew.-% ungesättigte Carbonsäure(derivate).

Bevorzugte Copolymerisate enthalten 20 bis 50 Gew.-% der Komponente a).

Geeignete Komponenten a) sind α-Cyanacrylsäureester mit 1 bis 8 C-Atomen im Alkoholrest, Maleinsäuredinitril, Fumarsäuredinitril und vor allem Acrylnitril und α-Alkylacrylnitrile, wie Methacrylnitril.

Geeignete Komponenten b) sind:
Styrol, α-Methylstyrol, o-Chlorstyrol, p-Chlorstyrol, o-, m-oder p-Methylstyrol, p-tert.-Butylstyrol oder Methylmethacrylate oder deren Mischungen.

Beispiele für Komponenten c) sind: Acrylsäurealkylester mit 1 bis 18 C-Atomen im Alkoholrest oder Methacrylsäurealkylester mit 2 bis 18 C-Atomen im Alkoholrest oder deren Mischungen.

Beispiele für Komponenten d) sind: β-monoolefinisch ungesättigte Mono-oder Dicarbonsäuren mit 3 bis 5 C-Atomen oder Maleinsäurehalbester mit 2 bis 18 C-Atomen im Alkoholrest oder deren Mischungen.

Die erfindungsgemäß zu verwendenden Bindemittel haben ein mittleres Molekulargewicht von 1.000 bis 1.000.000, bevorzugt von 2.000 bis 100.000. Sie werden nach üblichen Polymerisationsverfahren hergestellt, wobei die Polymerisationstemperaturen zwischen 20 bis 200 °C, bevorzugt zwischen 50 und 170 °C, liegen, und bei Drücken zwischen $10^3$ mbar und $2 \cdot 10^4$ mbar gearbeitet wird. Es hat sich als vorteilhaft erwiesen, die Copolymerisation in Lösung durchzuführen.

Als besonders geeignet haben sich lineare aromatische Polyurethanelastomere erwiesen, wie sie beispielsweise aus Butandiolpolyadipat, Neopentylglykol und 4,4'-Diphenylmethandiisocyanat hergestellt werden.

Zur Erhöhung der Haftfestigkeit der Substanzen auf den Oberflächen kann es auch erforderlich sein, den erfindungsgemäßen Bindemitteln Polyisocyanate oder freie Isocyanatgruppen enthaltende Oligo-oder Polyurethane zuzugeben. Als besonders günstig haben sich hierbei Zusätze erwiesen, die freie aliphatische Isocyanatgruppen enthalten.

Als Beispiele seien genannt:
Organische Polyisocyanate, wie sie z.B. gemäß EP-A-0 160 913 erhalten werden. Dabei handelt es sich um Biuretpolyisocyanate auf Basis von 1,6-Diisocyanatohexan, Isocyanatgruppen aufweisende Polyisocyanate auf Basis von 1-Isocyanato-3,3,5-trimethyl-5-isocyanatomethyl-cyclohexan und Isocyanuratgruppen aufweisende Polyisocyanate auf Basis von Gemischen von 1,6-Diisocyanatohexan und 1-Isocyanato-3,3,5-trimethyl-5-isocyanatomethylcyclohexan, Biuretgruppen aufweisende Polyisocyanate, wie sie beispielsweise gemäß DE-A 1 101 394 (= US 3 124 605), US 3 358 010 oder EP-PS 3505 (= US - 4 264 519) zugänglich sind. Uretdion-und Isocyanuratgruppen aufweisende organische Polyisocyanate, wie sie z.B. nach der Lehre der DE-A 1 954 093 (= GB 1 244 416) oder nach EP 0 173 252 erhalten werden.

Besonders geeignet sind Substanzen, die neben den Aktivatoren und den erfindungswesentlichen Bindemitteln Lösungsmittel, Füllstoffe sowie gegebenenfalls Tenside u.a. Hilfsmittel enthalten.

Als Lösungsmittel kommen in der Druck-bzw. Lackiertechnik bekannte Substanzen in Betracht, wie aromatische und aliphatische Kohlenwasserstoffe, beispielsweise Toluol, Xylol, Benzin, Petrolether; Glyzerin; Ketone, beispielsweise Aceton, Methylethylketon, Cyclohexanon, Methylisobutylketon; Ester, beispielsweise Essigsäurebutylester, Phthalsäuredioctylester, Glykolsäurebutylester, Glykolether, beispielsweise Ethylenglykolmonomethylether, Diglyme, Propylenglykolmonomethylether; Ester von Glykolethern, beispielsweise Ethylglykolacetat, Propylenglykolmonomethyletheracetat; Halogenkohlenwasserstoffe, Diacetonalkohol, in Betracht. Selbstverständlich können auch Gemische dieser Lösungsmittel und ihre Verschnitte mit anderen Lösungsmitteln eingesetzt werden.

Besonders bevorzugt werden Cyclohexanon und/oder Ethylenglykolmonomethyletheracetat.

Als Füllstoffe kommen aus der Druck-bzw. Lackierungstechnik bekannte Hilfsstoffe wie Pigmente, disperse Kieselsäuren, Tonmineralien, Ruße und rheologische Additive in Betracht.

Als Beispiele seien genannt:
Aerosile, $TiO_2$, Talkum, Eisenoxide, Kieselgur, Schwerspate, Kaoline, Quarzmehl, Smectite, Farbruße, Graphite, Zinksulfide, Chromgelb, Bronzen, organische Pigmente und Kreide.

Die Substanzen können zur Verbesserung ihrer Eigenschaften auch Verlaufsmittel (z.B. Silicone, Tenside) und Farbstoffe enthalten.

Die Herstellung der Substanzen geschieht im allgemeinen durch Vermischen der Bestandteile. Dazu sind neben dem einfachen Rühren besonders die in der Lack-und Drucktechnik üblichen Naßverkleinerungsaggregate wie Kneter, Attritore, Walzenstühle, Dissolver, Rotor-Stator-Mühlen; Kugelmühlen sowie Rührwerkmühlen besonders geeignet. Selbstverständlich kann das Einarbeiten der Formulierungsbestandteile auch in getrennten Schritten durchgeführt werden. Beispielsweise kann man den Aktivator zuerst in den Bindern und Lösungsmitteln lösen bzw. dispergieren und dann erst die Füllstoffe einarbeiten. Auch ein vorheriges Einbringen der Füllstoffe in die Lösungsmittel unter hohen Scherkräften ist eine mögliche Verfahrensvariante.

Durch Aufbringen der Substanzen können Oberflächen zum Zweck einer haftfesten chemogalvanischen Metallisierung aktiviert werden. Das Aufbringen erfolgt im allgemeinen durch aus der Lack-bzw. Drucktechnik bekannte Verfahren.

Als Beispiele seien genannt:
Aufsprühen, Aufpinseln, Aufrollen, Offsetdruck, Siebdruck, Tampondruck, Tauchen.

Als Substrate für das erfindungsgemäße Verfahren eignen sich Glas, Quarz, Keramik, Emaille, Papier, Polyethylen, Polypropylen, Epoxidharze, Polyester, Polycarbonate, Polyamide, Polyimide, Polyhydantoine, ABS-Kunststoffe, Silikone, Polyvinylhalogenide, Polyvinilidenfluorid in Form von Platten, Folien, Papieren und Vliesen. Besonders bevorzugt sind Substrate, wie sie in der Leiterplattenfertigung eingesetzt werden, z.B. Phenolharzpapiere, glasfaserverstärkte Epoxidplatten, Polyester-, Polyimidfolien und Keramik.

Geeignete Aktivatoren sind insbesondere solche, die in den EP-A 34 485, EP-A-81 438 oder EP-A-131 195 aufgeführt sind.

Nach dem Aufbringen der Substanzen auf die Oberfläche werden die Lösungsmittel entfernt. Im allgemeinen geschieht dies durch Trocknen.

Das Trocknen kann bei unterschiedlichen Temperaturen, beispielsweise zwischen RT und 200 °C und unter Normaldruck oder auch im Vakuum erfolgen. Die Trocknungszeit kann selbstverständlich stark variiert werden. Häufig genügen kurze Zeiten.

Die so bekeimten Oberflächen müssen anschließend durch Reduktion aktiviert werden. Dazu können bevorzugt die in der Galvanotechnik üblichen Reduktionsmittel, wie z.B. Formaldehyd, Hypophosphit, Borane, Hydrazinhydrat verwendet werden. Natürlich sind auch andere Reduktionsmittel möglich.

Eine besonders bevorzugte Ausführungsform bei Verwendung der Substanzen besteht darin, daß die Reduktion im Metallisierungsbad gleich mit dem Reduktionsmittel der stromlosen Metallisierung durchgeführt wird. Diese Ausführung ist besonders für aminoboranhaltige Nickelbäder oder formalinhaltige Kupferbäder geeignet.

Die mit den Substanzen aktivierten Oberflächen können in einem weiteren Verfahrensschritt stromlos metallisiert werden. Dafür kommen besonders Bäder mit Nickel-, Kobalt-, Eisen-, Kupfer-, Silber-, Gold-und Palladiumsalzen oder deren Gemische in Betracht. Derartige Metallisierungsbäder sind in der Technik der stromlosen Metallisierung bekannt.

Die Substanzen eignen sich besonders für eine partielle Aktivierung von Oberflächen, ganz besonders zur Herstellung von gedruckten Schaltungen, Folientastaturen, Schaltmatten und Sensoren nach üblichen Druckverfahren, wie z.B. Siebdruck, und anschließender additiven chemischen Metallisierung.

Der Erfindung liegt ferner die Aufgabe zugrunde, ein Verfahren zum Herstellen von gedruckten elektrischen Strukturen, insbesondere von mehrlagigen gedruckten elektrischen Strukturen zu schaffen, das es erlaubt, Strukturen höchster Genauigkeit herzustellen. Dabei soll gewährleistet sein, daß die nach dem Verfahren hergestellten Strukturen auch bei geringster Dicke und Breite fest an der Unterlage haften.

Die Erfindung geht aus von einem Verfahren zum Herstellen von elektrisch leitenden Strukturen durch stromlose Metallabscheidung auf einer insbesondere isolierenden Oberfläche eines Trägers, insbesondere in einem Metallisierungsbad, insbesondere einem formalinhaltigen Kupfer-oder hypophosphit-bzw. aminboranhaltiges Nickelbad, bei dem in Drucktechnik auf die Oberfläche des Trägers ein-oder beidseitig eine Substanz, die organometallische Aktivatoren, Füllstoffe, organische Lösungsmittel und Bindemittel enthält, entsprechend der Struktur aufgedruckt wird und bei dem nach Trocknung der aufgedruckten Substanz der Träger mit der bedruckten Oberfläche dem Metallisierungsbad zum Zwecke der Abscheidung von Metall auf dem mit der aufgedruckten Substanz aktivierten Teil der Oberfläche ausgesetzt wird. Bei einem solchen Verfahren wird eine Substanz verwendet, die als Füllstoff disperse Kieselsäuren, Bariumsulfat und/oder Ruß und als Bindemittel Polyurethane und/oder acrylnitrilhaltige Copolymerisate enthält.

Bei einer vorteilhaften Anwendung des Verfahrens wird insbesondere im Durchlauf auf ein Band die Struktur aufgebracht. Dabei kann das Aufdrucken der Formulierung rotativ und/oder von Rolle zu Rolle erfolgen.

Während bei Verwendung einer im Siebdruckverfahren aufgebrachten Silberleitpaste ein Leiterbahndicke von 8 bis 12 $\mu$m notwendig ist, kommt man beim erfindungsgemäßen Verfahren mit einer Dicke von ca 2 $\mu$m für Kupferleiter aus. Trotz dieser unterschiedlichen Dicke ergibt sich bei den Kupferleitern noch ein um den Faktor 3 geringerer Leitungswiderstand. Bei gleicher Metallschichtdicke ist also der Leitungswiderstand um mehr als einen Faktor 10 kleiner.

Zur Überraschung wurde festgestellt, daß es bei der Metallabscheidung auch bei längerer Behandlung im Metallisierungsbad nicht zu einem Breitenwachstum der Struktur kam, sondern die Metallabscheidung auf den mit der Formulierung bedruckten Bereich beschränkt blieb. Dieser Effekt ermöglicht eine hohe Fertigungsgenauigkeit. Mit dem Verfahren lassen sich deshalb gleichmäßige Strichbreiten, z.B. Leiterbahnen ab ca 0,01 mm erreichen. Dies ermöglicht die weitere Miniatisierung von gedruckten Schaltungen, insbesondere Abstände gleicher Größenordnung zwischen den Leiterbahnen bzw. anderen Strukturen.

Die Anwendungsmöglichkeiten der nach dem erfindungsgemäßen Verfahren hergestellten Schaltungen sind vielfältig, z.B. flexible und starre Schaltungen bzw. Strukturen, Abschirmungen, Tastaturen, Sensoren, Endlosleiter, Folienverbinder.

Gegenstand der Erfindung ist weiterhin eine mehrlagige gedruckte elektrische Schaltung, deren elektrisch leitende Strukturen in den einzelnen Lagen durch insbesondere aufgedruckte, isolierende Zwischenlagen elektrisch voneinander getrennt sind. Bei dieser Schaltung ist erfindungsgemäß vorgesehen, daß die Strukturen aus mittels einer einen Aktivator enthaltenden Substanz stromlos auf der isolierenden Oberfläche des Trägers und der jeweiligen isolierenden Zwischenlage abgeschiedenen Metallschicht bestehen. Sofern die Strukturen in den einzelnen Lagen elektrisch miteinander verbunden sein sollen, ist weiter vorgesehen, daß die isolierenden Zwischenlagen Aussparungen für die Durchkontaktierung aufweisen und im Bereich der Aussparungen auf die Struktur der jeweiligen unteren Lage die Substanz vollflächig oder partiell aufgedruckt ist. Bei dieser Ausgestaltung wird ein elektrisch leitfähiger Kontakt zwischen der unteren Metallschicht, auf der die Substanz vollflächig oder partiell aufgedruckt ist, und der auf der Substanz stromlos abgeschiedenen Metallschicht überraschenderweise erhalten.

Die Substanz enthält vorzugsweise die erwähnten Bestandteile.

Vorteilhafte und bevorzugte Ausgestaltungen der Erfindung sind in den Unteransprüchen gekennzeichnet.

Der Träger mit der aufgedruckten elektrisch leitfähigen Struktur oder die mehrlagige gedruckte elektrische Schaltung läßt sich mit herkömmlichen gedruckten Schaltungen wegen ihrer geringen Höhe in vorteilhafter Weise kombinieren. Beispielsweise ist es möglich, bei Leiterplatten, die durch Verpressen von zum Beispiel in Fotoätztechnik hergestellten Platten, die elektrisch leitende Strukturen tragen, oder isolierenden Zwischenschichten (Prepegs) hergestellt werden, für die Lagen, die elektrisch leitende Strukturen tragen, die erfindungsgemäßen Träger mit den elektrisch leitenden Strukturen bzw. die mehrlagigen Schaltungen zu verwenden.

Gegenstand der Erfindung ist schließlich ein Verfahren zum Herstellen von mehrlagigen gedruckten elektrischen Schaltungen (Multilayer), insbesondere in Siebdrucktechnik, bei dem jeweils durch Aufdrucken einer Substanz, die organometallische Aktivatoren, Füllstoffe, organische Lösungsmittel und Bindemittel enthält, in einem ersten Verfahrensschritt auf der isolierenden Oberfläche eines Trägers eine elektrisch leitende Struktur, in einem zweiten Verfahrensschritt auf den bedruckten Träger unter Aussparung eines oder mehrerer vorgegebener Bereiche der elektrisch leitenden Struktur eine Isolierschicht und in einem dritten Verfahrensschritt auf der Isolierschicht und jeden ausgesparten Bereich eine weitere elektrisch leitende Struktur aufgebracht wird, wobei der zweite und dritte Verfahrensschritt entsprechend der geforderten Anzahl von Lagen wiederholt wird. Bei einem solchen Verfahren ist die Erfindung dadurch gekennzeichnet, daß das Aufdrucken der jeweiligen elektrisch leitenden Struktur durch Aufdrucken der Substanz, die als Füllstoff disperse Kieselsäuren, Bariumsulfat und/oder Ruß enthält und als Bindemittel Polyurethane und/oder acrylnitrilhaltige Copolymerisate enthält, und nach Trocknung der Substanz durch anschließende stromlose Metallabscheidung auf dem aktivierten Teil der Oberfläche des Trägers bzw. der Isolierschicht in einem Metallisierungsbad erfolgt, wobei die Substanz auch auf den im Bereich einer Aussparung liegenden Teil des abgeschiedenen Metalls aufgebracht wird.

Als Bindemittel kommen die auf den Seiten 8 bis 14 genannten Substanzen in Betracht.

Als Metallisierungsbad eignet sich vor allem ein formalinhaltiges Kupfer-aber auch ein hypophosphit-bzw. aminboranhaltiges Nickelbad. Aber auch andere ein Reduktionsmittel enthaltende Metallsalzbäder können verwendet werden.

Beim Aufdrucken der Substanz hat man besonders gute Erfahrungen mit der Siebdrucktechnik (Durchdruck) gemacht. Aber auch andere Druckverfahren, wie Hochdruck (Buchdruck), Tiefdruck, Flachdruck (Offsetdruck) und Tampondruck sind geeignet.

Freiliegende elektrisch leitfähige Strukturen, die unter der Einwirkung von Witterung anlaufgefährdet sind, lassen sich auf herkömmliche Art und Weise durch Überziehen mit einem Schutzfilm, gegebenenfalls einem elektrisch leitfähigen Schutzfilm, z.B. durch Tauchen, schützen. Es ist aber auch möglich, die freiliegenden metallischen Strukturen durch stromlose Metallabscheidung oder galvanische Metallabscheidung in entsprechenden Metallisierungsbädern, z.B. Nickel-oder Goldbädern abschließend zu behandeln.

Das erfindungsgemäße Verfahren ist vor allem für die Herstellung von mehrlagigen gedruckten Schaltungen (Multilayer) deshalb geeignet, weil die Materialdicke der elektrisch leitenden Strukturen bei ausreichend kleinem Leitungswiderstand klein gehalten werden kann. Daraus resultiert, daß auch bei einer großen Anzahl von Lagen die Oberfläche der Schaltung nicht wellig wird, sondern eben bleibt und die gesamte Dicke der mehrlagigen gedruckten Schaltung im Vergleich zu in herkömmlicher Siebdrucktechnik mit Metallpaste hergestellten Schaltungen klein bleibt.

Im folgenden wird die Erfindung anhand einer Ausführungsbeispiele der Erfindung darstellenden schematischen Zeichnung näher erläutert. Im einzelnen zeigen:

Fig.1 eine zweilagige gedruckte elektrische Schaltung im Querschnitt,

Fig.2 ein Band mit endlos bedruckten elektrisch leitenden Strukturen in Aufsicht,

Fig.3 das Band gem. Fig.2 im Querschnitt nach der Linie I - I und

Fig.4 eine unter Verwendung von erfindungsgemäßen elektrisch leitenden Strukturen und/oder Schaltungen und isolierenden klebfähigen Zwischenlagen verpreßte Leiterplatte im Querschnitt.

Bei einer erfindungsgemäßen mehrlagigen gedruckten Schaltung ist auf einem Träger 1, der insbesondere auf der zu bedruckenden Seite elektrisch isoliert ist, in verschiedenen Verfahrensschritten eine mehrlagige gedruckte Schaltung aufgebaut. Als Trägermaterial sind vor allem Polyester und Polyimide, aber auch glasfasergefüllte Epoxymaterialien, Phenolharzpapiere, Teflon, Polycarbonat, Polyäthylen, PVDF, Papier, Quarz, Keramik, Glas, Stahl, Aluminium geeignet. Denkbar ist aber auch, daß die elektrische Schaltung auf eine mit einem Isolierlack abgedeckte Oberfläche eines metallischen Trägers aufgebracht wird. Auf die insbesondere isolierte Oberfläche wird vorzugsweise im Siebdruckverfahren für die herzustellende elektrisch leitfähige Struktur der ersten Lage eine Substanz als pastöse Substanz 2 aufgebracht, die einen Aktivator für die stromlose Metallabscheidung enthält. Nach Aufdrucken wird die Substanz 2 getrocknet und ausgehärtet, so daß sie eine feste Verbindung mit der Oberfläche des Trägers 1 eingeht. Die Trocknung erfolgt vorzugsweise bei Temperaturen von 150 bis 200 °C.

Der mit der Substanz 2 bedruckte Träger 1 wird anschließend in einem Metallisierungsbad für die stromlose Abscheidung von Metall getaucht und in dem Metallisierungsbad so lange belassen, bis daß sich auf dem mit der Substanz 2 bedruckten Bereich eine ausreichend dicke Schicht reinen Metalls für die elektrisch leitfähige Struktur 3 abgeschieden hat. Anschließend, gegebenenfalls nach einer Reinigung der bedruckten Seite, wird der Träger 1 einschließlich der abgeschiedenen Metallschicht vorzugsweise im Siebdruckverfahren mit einer Isolierlackschicht 4 bis auf einen Bereich abgedeckt, wo eine Kontaktierung zur nächsten Lage erfolgen soll.

Auf die Isolierlackschicht 4 und den nicht mit Isolierlack abgedeckten Bereich des abgeschiedenen Metalls, zu dem die Bezugslinie des Bezugszeichens für die Struktur 3 führt, wird vorzugsweise im Siebdruckverfahren die Substanz 5 entsprechend dem Strukturbild für die zweite Lage aufgedruckt. Wie bei der aufgedruckten Substanz 2 für das Leiterbild der ersten Lage wird nach Trocknung der Substanz 5 im Metallisierungsbad reines Metall für die Struktur 6 auf den mit der Substanz 5 bedruckten Bereich abgeschieden. Während im Bereich der Isolierlackschicht 4 die übereinander liegenden Strukturen 3,6 gegeneinander isoliert sind, ergibt sich im Bereich der Aussparung der Isolierlackschicht 4 trotz der zwischen den Strukturen 3, 6 aufgebrachten Schicht der dielektrischen Formulierung 5 eine elektrische Verbindung.

Abschließend kann im Siebdruckverfahren eine weitere Schicht 7 aus Isolierlack aufgebracht werden. Dabei können wieder bestimmte Bereiche 8 für Kontaktzwecke ausgespart bleiben, die gegenüber Witterungseinflüssen durch einen Überzug 9, in diesem Fall gegenüber äußeren Einflüssen, zum Beispiel Korrosion, geschützt sind. Der Überzug kann durch galvanische oder stromlose Metallabscheidung aufgebracht sein.

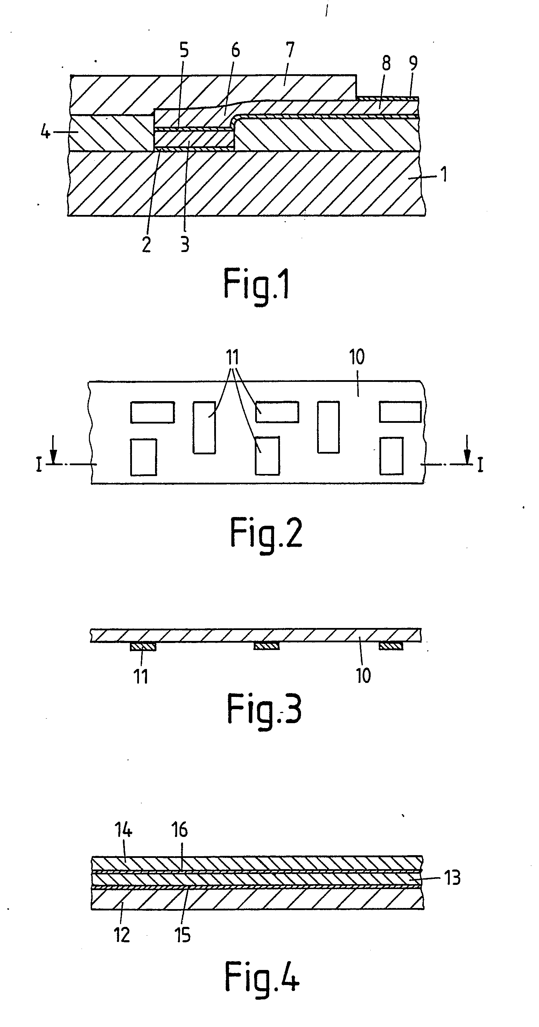

Bei dem Band gemäß Figur 2 und 3 wird, wie beim Ausführungsbeispiel der Figur 1 vorbeschrieben, entsprechend dem gewünschten Strukturbild im Druckverfahren die Substanz aufgedruckt. Dieses Aufdrucken kann im Durchlauf, insbesondere rotativ und/oder von Rolle zu Rolle erfolgen. Vor allem können beide Seiten des Trägers 10 bedruckt werden. Nach dem Trocknen der Substanz wird gleichzeitig beidseitig im Metallisierungsbad auf den Bereichen mit der Substanz Metall zur Bildung der gewünschten Strukturen 11 abgeschieden.

Beim Ausführungsbeispiel der Figur 4 wird von einer Grundplatte 12 ausgegangen, die ein aus einer aufkaschierten Metallfolie durch Ätzen gebildetes Leiterbild 12 trägt. Auf dieser Grundplatte 12 sind zwei erfindungsgemäße, mehrlagige elektrische Schaltungen 13,14 zusammen mit isolierenden Zwischenschichten 15,16 aus einem klebfähigem Material (Prepregs) durch Verpressen aufgebracht Der Einsatz einer derart kombinierten Leiterplatte ermöglicht es, z.B. das Leiterbild auf der Grundplatte 12 als Stromverteilung zu benutzen, weil die aufkaschierte Metallfolie verhältnismäßig dick und deshalb zur Führung hoher Ströme ausgelegt sein kann. Selbstverständlich lassen sich derart dicke Leiterbahnen beim erfindungsgemäßen Verfahren herstellen. Nach dem erfindungsgemäßen Verfahren hergestellte Leiterbahnen sind aber auch für filigrane Strukturen geeignet, die nur geringe Ströme zu führen brauchen. Insgesamt ergibt sich bei dieser Kombination im Vergleich zu nach herkömmlicher Ätztechnik hergestellten verpreßten Leiterplatten eine wesentlich geringere Höhe.

Zur stromlosen Metallabscheidung können handelsübliche formalinhaltige Kupferbäder eingesetzt werden. Sie enthalten z.B. 2 g/l Cu, 5 g/l NaOH und 10 g/l Formaldehyd. Als Substanzen werden insbesondere die auf den Seiten 8 bis 14 genannten Substanzen eingesetzt.

Als isolierende Zwischenschicht eignen sich verschiedene auf Lösungsmittelbasis oder UV härtende Lacke, z.B. Polyesterlacke, Alkydharzlacke, Polyurethanlacke und Epoxidharzlacke.

In den folgenden Beispielen sind einige für die vorliegende Erfindung besonders geeignete Substanzen aufgeführt.

## Beispiel 1

In einem 12l VA-Autoklaven mit Ankerrührer und Temperaturregelung werden
2600 Gew.-Teile Propylenglykolmonomethyletheracetat (PMA)
vorgelegt. Der Autoklav wird bei Raumtemperatur zur Entfernung von Sauerstoff auf ca. 20 mbar evakuiert und sodann 3 mal mit 2 bar Stickstoff gespült. Sodann wird Stickstoff bis zu einem Überdruck von 0,5 bar aufgedrückt. Es wird eine Rührerdrehzahl von 100 U/min eingestellt und auf eine Innentemperatur von 120 °C geheizt. Sodann werden über 2 Dosierpumpen innerhalb von 4 Stunden folgende Mischungen gleichmäßig zudosiert:

Monomerenmischung I: 978 Gew.-Teile    Styrol
978 Gew.-Teile    Methylmethacrylat
978 Gew.-Teile    n-Butylacrylat
1954 Gew.-Teile    Acrylnitril.

Initiatorlösung II: 100 Gew.-Teilen    tert. Butylperoctoat, gelöst in
580 Gew.-Teilen    PMA.

Nach beendeter Dosierzeit wird 30 Minuten bei 120 °C nachgerührt und sodann eine zweite Initiatorlösung aus
16,8 Gew.-Teilen    Di-tert.-Butylperoxid, gelöst in
84 Gew.-Teilen    PMA
zugedrückt. Zur Auspolymerisierung wird noch 4 Stunden bei 120 °C nachgerührt. Nach Abkühlung auf 80 °C wurde die hochviskose Lösung über das Bodenventil des Autoklaven abgelassen.
Ausbeute: 8130 g Lösung
Die Konzentration der Lösung betrug 58,8%, die Viskosität in 30%iger Lösung in PMA 1300 mPa.s bei 25 °C.

Die Lösung bildet auf Glas und Polyesterfolien nach dem Austrocknen einen gut haftenden, leicht gelblichen transparenten Film.

## Beispiel 2

Gemäß Beispiel 1 wurden
2444 Gew.-Teile    Methylmethacrylat
978 Gew.-Teile    n-Butylacrylat
und 1466 Gew.-Teile    Acrylnitril
als Monomerenmischung eingesetzt und bei einer Temperatur von 100 °C zudosiert und nachpolymerisiert. Es wurden 7950 g Polymerlösung mit einem Feststoffgehalt von 60,1 Gew.-% erhalten. Die unverdünnte Lösung hatte eine Viskosität von 140.800 mPa.s bei 25 °C. Die Lösung bildete beim Auftrocknen einen schwach gelblichen, transparenten Film.

## Beispiel 3

Es wurde gemäß Beispiel 2 verfahren, jedoch bei 120 °C zudosiert und nachpolymerisert.

Es wurden 8050 g Polymerlösung mit einem Feststoffanteil von 60,1 Gew.-% erhalten. Die Viskosität der unverdünnten Lösung betrug 48.000 mPa.s bei 25 °C. Der beim Auftrocknen aus der Lösung gebildete Film war transparent und gelbbraun gefärbt.

## Beispiel 4

Gemäß Beispiel 1 wurden
3421 g    Methylmethacrylat
978 g    n-Butylacrylat
und 489 g    Acrylnitril
als Monomerenmischung eingesetzt und unter sonst gleichen Bedingungen polymerisiert.

Es wurden, 8100 g Polymerlösung mit einem Feststoffgehalt von 60 Gew.-% erhalten. Die Viskosität der Lösung betrug 3000 mPa.s bei 25 °C. Nach Trocknung bildete die Lösung einen klaren transparenten Film.

## Beispiel 5

66 Gew.-Teile    einer Polymerlösung gemäß Beispiel 4
50 Gew.-Teile    Ethylenglykolmonomethyletheracetat
4 Gew.-Teile    Aerosil und
1 Gew.-Teil    3-Hepton-2-on-palladiumchlorid
werden über einen Drei-Walzenstuhl sorgfältig vermischt.

Die so erhaltene Paste wird durch ein Sieb auf eine PES-Folie gedruckt und der Druck 30 Minuten bei 150 °C getrocknet. Anschließend wird der Druck 5 Minuten in einer 1%igen wäßrigen Dimethylaminboranlösung reduziert, sorgfältig gespült und dann 1 Stunde in einem alkalischen formalinhaltigen Kupferbad (1,7 g/l Kupfer, 5g/l NaOH, 8 g/l Formalin) bei 60 °C metallisiert. Man erhält eine zusammenhängende Kupferschicht.
Haftfestigkeit gemäß DIN 53 151, Kennwert GT 4.

## Beispiel 6

Gemäß Beispiel 5 wird eine Druckpaste mit einem Polymer gemäß Beispiel 2 hergestellt und eine PES-Folie damit bedruckt und verkupfert. Man erhält eine zusammenhängende Kupferschicht.
Haftfestigkeit gemäß DIN 53 151, Kennwert GT 3.

## Beispiel 7

Gemäß Beispiel 5 wird eine Siebdruckpaste mit einem Bindemittel gemäß Beispiel 1 hergestellt und eine PES-Folie damit bedruckt und verkupfert. Man erhält eine zusammenhängende Kupferschicht.
Haftfestigkeit gemäß DIN 53 151: Kennwert GT 1
Haftfestigkeit gemäß DIN 53 494: 11 N.

## Beispiel 8

260 Gew.-Teile    ·    einer Polymerlösung gemäß Beispiel 1
290 Gew.-Teile    Ethylenglykolmonomethyletheracetat
120 Gew.-Teile    Glykolsäurebutylester
40 Gew.-Teile    Aerosil und
6 Gew.-Teile    Butadienpalladiumchlorid
werden in einem Dissolver vermischt. Die so erhaltene Paste wird durch ein Sieb auf eine PES-Folie gedruckt und der Druck 1 Stunde bei 100 °C getrocknet. Anschließend wird der Druck 30 Minuten in einem aminboranhaltigen Nickelbad vernickelt. Man erhält eine zusammenhängende Nickelschicht.
Haftfestigkeit gemäß DIN 53 494: 14 N
Viskosität der Druckpaste: 3600 mPa.s.

## Beispiel 9

Mit einer Druckpaste gemäß Beispiel 8 wird ein Leiterbahnbild auf eine glasfaserverstärkte Epoxidharzplatte (FR-4 Material) gedruckt. Anschließend wird die Oberfläche bei 150 °C 1 Stunde getrocknet und 1 Stunde in einem Verkupferungsbad gemäß Beispiel 5 verkupfert. Man erhält ein abbildungsgenaues Leiterbahnbild mit einer Kupferauflage von 3 μm.
Haftfestigkeit analog DIN 53 151: Kennwert GT 1.

## Beispiel 10

480 Gew.-Teile einer Polymerlösung in Ethylenglykolethyletheracetat mit einem Feststoffgehalt von 30%, bestehend aus einem Copolymeren, hergestellt gemäß Beispiel 1 aus
20 Gew.-Teilen    Acrylnitril
20 Gew.-Teilen    Methacrylnitril
20 Gew.-Teilen    Methylmethacrylat
20 Gew.-Teilen    Styrol
20 Gew.-Teilen    n-Butylacrylat
20 Gew.-Teilen    eines Smectides (Bentone® 38)
8 Gew.-Teilen    Bisacetonitrilpalladiumdichlord
werden sorgfälitig im Dissolver vermischt.
Die entstehende Mischung wird mit einem Rakel auf eine Tyvek-Papieroberfläche gestrichen, 2 Stunden bei 80 °C getrocknet und anschließend gemäß Beispiel 5 vorreduziert und verkupfert. Man erhält eine zusammenhängende Kupferschicht.

## Beispiel 11

Analog Beispiel 1 wird eine 40%ige Lösung in PMA eines Copolymeren hergestellt, bestehend aus
15 Gew.-Teilen    Styrol
20 Gew.-Teilen    Methylmethacrylat
20 Gew.-Teilen    n-Butylacrylat
25 Gew.-Teilen    Acrylnitril
20 Gew.-Teilen    α-Cyanacrylsäurebutylester.
180 Gew.-Teile    dieser Lösung werden gemäß Beispiel 10
mit 90 Gew.-Teilen    Ethylenglykolmethyletheracetat
2 Gew.-Teilen    Butadienpalladiumdichlorid
und 17 Gew.-Teilen    Aerosil
vermischt.
Die dabei entstehende Druckpaste wird gemäß Beispiel 8 auf eine PES-Folie gedruckt, getrocknet und metallisiert. Man erhält eine vernickelte Folie.
Haftfestigkeit nach DIN 53 151: Kennwert GT 1.

## Beispiel 12

Aus Butandiolpolyadipat (NG 2000), Neopentylglykol und 4,4-Diphenylmethan-diisocyanat wird ein nicht reaktives Polyurethanelastomer hergestellt.
100 Gew.-Teile    einer 30%igen Lösung dieses Polyurethans in    Ethylenglykolethyletheracetat (Viskosität bei 25 °C 1250 mPa.s)
20 Gew.-Teile    eines Farbrußes (Printex® V)
2 Gew.-Teile    3-Heptan-2-on-palladiumchlorid und
2 Gew.-Teile    Diethylenglykol
werden über einen Drei-Walzenstuhl sorgfältig miteinander vermischt bzw. dispergiert.

Die entstehende Paste wird durch ein Sieb auf eine Tyvak-Papieroberfläche gestrichen, 1 Stunde im Wasserstrahlvakuum bei 50 °C getrocknet und anschließend in einem aminboranhaltigen Nickelbad metallisiert. Man erhält eine zusammenhängende Nickelschicht. Haftfestigkeit gemäß DIN 53 151: Kennwert GT 3.

## Beispiel 13

20 Gew.-Teile einer 30%igen Lösung eines Polyurethans gemäß Beispiel 1 in N-Methylpyrolidon: Ethylenglykolethyletheracetat = 1 : 1
4 Gew.-Teile eines FarbruBes (Printex® V)
2 Gew.-Teile 5-Methyl-3-hexan-2-on-palladiumchlorid und
2 Gew.-Teile Dioktylphathalat
werden über einen Drei-Walzenstuhl sorgfältitg miteinander vermischt bzw. dispergiert.

Die entstehende Paste .wird durch ein Sieb auf eine Polyvinylidendifluoridfolie gedruckt und der Druck anschließend 2 Stunden bei 100 °C im Wasserstrahlvakuum getrocknet. Danach wird der Druck in einem aminboranhaltigen Nickelbad 30 Minuten metallisiert. Man erhält eine zusammenhängende Metallschicht. Haftfestigkeit gemäß DIN 53 151: Kennwert GT 5.

## Beispiel 14

20 Gew.-Teile einer 30%igen Polyurethanlösung gemäß Beispiel 13
4 Gew.-Teile Aerosil® (200 m²/g nach BET)
20 Gew.-Teile Ethylenglykolethyletheracetat
4 Gew.-Teile eines handelsüblichen Einbrennurethanharzes auf Basis Isophorondiisocyanat/Malonester blockiert ca. 75% Lösung in Ethylglykolacetat/Xylol 1:1 NCO-Gehalt blockiert ca. 10%
1 Gew.-Teil 5-Methyl-3-hexan-2-on-palladiumchlorid
werden im Dissolver sorgfältig vermischt bzw. dispergiert.

Die entstehende Paste wird durch ein Sieb auf eine gedruckt und der Druck 1 Stunde bei 150 °C getrocknet. Anschließend wird die Oberfläche 5 Minuten in einer 1%igen alkalischen Aminboranlösung vorreduziert, gespült und dann 1 Stunde in einem formalinhaltigen Kupferbad bei 60 °C verkupfert. Man erhält eine zusammenhängende Metallschicht der Dicke 2,8 μm.
Haftfestigkeit gemäß DIN 53 151: Kennwert: GT 3.

## Beispiel 15

60 Gew.-Teile einer 30%igen Polyurethanlösung gemäß Beispiel 13
1 Gew.-Teil Diacetonitrilpalladiumdichlorid
5 Gew.-Teile Aerosil® (380 m²/g nach BET)
30 Gew.-Teile Glykolethyletheracetat
1 Gew.-Teil Siliconöl M 100
werden über einen Drei-Walzenstuhl sorgfältig vermischt bzw. dispergiert und gemäß Beispiel 3 verdruckt, getrocknet und die Oberflächen verkupfert. Man erhält eine zusmmenhängende Metallschicht mit einer Haftfestigkeit gemäß DIN 53 494 von 36 N.

## Beispiel 16

100 Gew.-Teile einer 30%igen Polyurethanlösung gemäß Beispiel 1
9 Gew.-Teile Aerosil® (380 m²/g nach BET)
50 Gew.-Teile Glykolmethyletheracetat
16 Gew.-Teile eines Uretdion-und Isocyanuratgruppen aufweisenden Polyisocyanat auf Basis 1,6-. Diisocyanatohexan mit einem NCO-Gehalt von 22,7%
1,5 Gew.-Teile Tetrahydrophthalsäureanhydridpalladiumdichlorid
werden in einem Kneter sorgfältig miteinander vermischt.

Anschließend wird die entstehende Paste gemäß Beispiel 14 verdruckt und der Druck verkupfert. Man erhält eine zusammenhängende Metallschicht. Die Haftfestigkeit kann nach DIN 53 494 nicht mehr exakt bestimmt werden, da das Kupfer nicht zerstörungsfrei von der Polyesterfolie abgezogen werden kann.

## Beispiel 17

650 Gew.-Teile einer 30%igen Polyurethanlösung gemäß Beispiel 1
330 Gew.-Teile Glykolmethyletheracetat
55 Gew.-Teile Aerosil® (380 m²/g nach BET)
52 Gew.-Teile Helioechtblau GO
13 Gew.-Teile Butadienpalladiumchlorid
werden sorgfältig über einen Drei-Walzenstuhl vermischt bzw. dispergiert und gemäß Beispiel 14 auf eine PES-Folie gedruckt. Durch stromlose Verkupferung des Druckers erhält man eine Kupferschicht mit einer Haftfestigkeit gemäß DIN 53 494 von 21 N.

**Ansprüche**

1. Elektrisch leitende Struktur, bestehend aus einem Träger mit insbesondere isolierender Oberfläche und einer auf der Oberfläche mittels einer aufgedruckten Substanz stromlos aus einem Metallisierungsbad abgeschiedenen Metallschicht, wobei die Substanz organometallische Aktivatoren, Füllstoffe, organische Lösungsmittel und Bindemittel enthält, **dadurch gekennzeichnet,** daß als Füllstoff disperse Kieselsäuren, Bariumsulfat und/oder Ruß und als Bindemittel Polyurethane und/oder acrylnitrilhaltige Copolymerisate eingesetzt werden.

2. Elektrisch leitende Struktur gemäß Anspruch 1, **dadurch gekennzeichnet,** daß das Bindemittel ein Copolymerisat aus
a) einem cyangruppenhaltigen Monomeren
b) kernsubstituierten (Methyl) Styrol und/oder
c) (Meth) Acrylsäureester und/oder
d) ungesättigten Carbonsäuren oder deren Derivaten
ist.

3. Elektrisch leitende Struktur gemäß Anspruch 2, **dadurch gekennzeichnet,** daß
5 bis 80 Gew.-% der Komponente a),
5 bis 40 Gew.-% der Komponente b),
5 bis 40 Gew.-% der Komponente c) und
5 bis 40 Gew.-% der Komponente d)
in dem Bindemittel sind.

4. Struktur gemäß Anspruch 3, **dadurch gekennzeichnet,** daß 20 bis 50 Gew.-% der Komponente a) im Bindemittel sind.

5. Verwendung einer Substanz, die organometallische Aktivatoren, Füllstoffe, organische Lösungsmittel und Bindemittel enthält, zum Herstellen von elektrisch leitenden Strukturen durch stromlose Metallabscheidung auf einer insbesondere isolierenden Oberfläche eines Trägers, insbesondere in einem Metallisierungsbad, insbesondere einem formalinhaltigen Kupfer-oder hypophosphit-bzw. aminboranhaltigen Nickelbad, bei dem in Drucktechnik auf die Oberfläche des Trägers ein- oder beidseitig die Substanz entsprechend der Struktur aufgedruckt wird und bei dem nach Trocknung der aufgedruckten Substanz der Träger mit der bedruckten Oberfläche dem Metallisierungsbad zum Zwecke der Abscheidung von Metall auf dem mit der aufgedruckten Substanz aktivierten Teil der Oberfläche ausgesetzt wird, **dadurch gekennzeichnet,** daß als Füllstoff disperse Kieselsäuren, Bariumsulfat und/oder Ruß und als Bindemittel Polyurethane und/oder acrylnitrilhaltige Copolymerisate eingesetzt werden.

6. Verwendung der Substanz nach Anspruch 5, **dadurch gekennzeichnet,** daß das Aufdrucken auf ein Band rotativ und/oder von Rolle zu Rolle erfolgt.

7. Verwendung der Substanz gemäß einem der Ansprüche 5 oder 6, **dadurch gekennzeichnet,** daß die Substanz in Siebdrucktechnik aufgebracht wird.

8. Mehrlagige gedruckte elektrische Schaltung, deren elektrisch leitende Strukturen in den einzelnen Lagen durch insbesondere aufgedruckte isolierende Zwischenlagen elektrisch voneinander getrennt sind, **dadurch gekennzeichnet,** daß die Strukturen (3, 6) aus mittels einer einen Aktivator enthaltenden Formulierung (2, 5) stromlos auf der insbesondere isolierenden Oberfläche eines Trägers (1) und der jeweiligen isolierenden Zwischenlage (4) abgeschiedenen Metallschicht bestehen.

9. Schaltung nach Anspruch 8, **dadurch gekennzeichnet,** daß die isolierenden Zwischenlagen (4) Aussparungen für die Durchkontaktierung aufweisen und im Bereich der Aussparungen auf die Struktur der jeweiligen unteren Lage (3) die Formulierung (5) vollflächig oder partiell aufgedruckt ist.

10. Schaltung nach Anspruch 8 oder 9, enthaltend eine aus organometallischen Aktivatoren, Füllstoffen, organischen Lösungsmitteln und Bindemitteln bestehende Substanz, **dadurch gekennzeichnet,** daß als Füllstoff disperse Kieselsäuren, Bariumsulfat und/oder Ruß und als Bindemittel Polyurethane und/oder acrylnitrilhaltige Copolymerisate eingesetzt werden.

11. Struktur oder Schaltung nach einem der Ansprüche 1 bis 4 sowie 8 bis 10, **gekennzeichnet durch** eine Dicke der Metallschicht von durch eine Dicke der Metallschicht von 0,5 $\mu$m bis 5 $\mu$m, insbesondere 2 $\mu$m.

12. Struktur oder Schaltung nach einem der Ansprüche 1 bis 4 sowie 8 bis 10, **gekennzeichnet durch** eine Breite der Metallschicht von 0,01 mm und mehr, insbesondere bis 1 mm.

13. Struktur oder Schaltung nach einem der Ansprüche 1 bis 4 sowie 8 bis 10, **gekennzeichnet** durch einen kleinsten Abstand von benachbarten Metallschichten von 0,01 mm bis 1 mm.

14. Struktur oder Schaltung nach einem der Ansprüche 1 bis 4 sowie 8 bis 10, **gekennzeichnet** durch eine Haftfestigkeit der Metallschicht von mehr als 10 N, insbesondere 15 N, DIN 53494.

15. Struktur oder Schaltung nach einem der Ansprüche 1 bis 4 sowie 8 bis 10, **dadurch gekennzeichnet,** daß der Träger ein Band, insbesondere in Rollenform, ist, auf dem die teil-oder vollflächige elektrisch leitfähige Struktur insbesondere endlos gedruckt ist.

16. 3. Verfahren zum Herstellen von mehrlagigen gedruckten elektrischen Schaltungen (Multilayer), in Drucktechnik, bei dem jeweils durch Aufdrucken einer Substanz, die organometallische Aktivatoren, Füllstoffe, organische Lösungsmittel und Bindemittel enthält, in einem ersten Verfahrensschritt auf der insbesondere isolierenden Oberfläche eines Trägers eine elektrisch leitende Struktur, in einem zweiten Verfahrensschritt auf den bedruckten Träger unter Aussparung eines oder mehrerer vorgegebener Bereiche der elektrisch leitenden Struktur eine Isolierschicht und in einem dritten Verfahrensschritt auf der Isolierschicht und jeden ausgesparten Bereich eine weitere elektrisch leitende Struktur aufgebracht wird, wobei der zweite und dritte Verfahrensschritt entsprechend der geforderten Anzahl von Lagen wiederholt wird, **dadurch gekennzeichnet,** daß das Aufdrucken der jeweiligen elektrisch leitenden Struktur durch Aufdrucken der Substanz, die als Füllstoff disperse Kieselsäuren, Bariumsulfat und/oder Ruß und als Bindemittel Polyurethane und/oder acrylnitrilhaltige Copolymerisate enthält, und nach Trocknung der Substanz durch anschließende stromlose Metallabscheidung auf dem mit der aufgedruckten Formulierung aktivierten Teil der Oberfläche des Trägers bzw. der Isolierschicht in einem Metallisierungsbad erfolgt, wobei die Substanz auch auf das im Bereich einer Aussparung liegende Teil des abgeschiedenen Metalls vollflächig oder partiell aufgebracht wird.

17. Verfahren nach Anspruch 16, **dadurch gekennzeichnet,** daß die Substanz in Siebdrucktechnik aufgedruckt wird.

18. Verfahren zum Herstellen von mehrlagigen Leiterplatten, **gekennzeichnet** durch die Verwendung von mindestens einer elektrisch leitenden Struktur oder Schaltung nach einem der Ansprüche 1 oder 2 sowie 6 bis 17, beim Verpressen von elektrisch leitende Strukturen tragende und isolierende, klebfähige Zwischenschichten (Prepregs) bildenden Lagen als die elektrisch leitfähige Struktur tragende Lage bzw. Lagen.

Fig.1

Fig.2

Fig.3

Fig.4

46 231

Europäisches
Patentamt

# EUROPÄISCHER RECHERCHENBERICHT

Nummer der Anmeldung

EP 87 11 4275

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.3) |
|---|---|---|---|
| X | DE-A-2 812 497 (PREH) <br> * Ansprüche 1,2,4,10 * <br> --- | 1,2,5,8 -10,16 | H 05 K 3/46 <br> H 05 K 3/18 |
| A | EP-A-0 169 060 (ELECTRO MATERIALS) <br> * Ansprüche 1,3,6,10-12 * <br> --- | 1,2,5,8 ,10,16 | |
| A | US-A-3 668 003 (FURNESS) <br> * Ansprüche 1,5 * <br> --- | 1,5-7, 15-17 | |
| A | US-A-3 745 045 (BRENNEMAN et al.) <br> * Ansprüche 1-4 * <br> --- | 1,5,8,9 | |
| A,D | DE-B-1 176 731 (PHOTOCIRCUITS) <br> * Ansprüche 1,3-6 * <br> --- | 1,5-9 | |
| A,D | FR-A-2 296 347 (MACHIDA) <br> * Ansprüche 1-6 * <br> --- | 1,8,9 | |
| A,D | DE-A-3 241 579 (AMP) <br> * Ansprüche 1-3 * <br> ----- | 1,2,5-7 ,16 | |

| | RECHERCHIERTE SACHGEBIETE (Int. Cl.3) |
|---|---|
| | H 05 K 3/00 |

Der vorliegende Recherchenbericht wurde für alle Patentansprüche erstellt

| Recherchenort | Abschlußdatum der Recherche | Prüfer |
|---|---|---|
| BERLIN | 08-02-1988 | HAHN G |

KATEGORIE DER GENANNTEN DOKUMENTE

X : von besonderer Bedeutung allein betrachtet
Y : von besonderer Bedeutung in Verbindung mit einer
     anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
     nach dem Anmeldedatum veröffentlicht worden ist
D : in der Anmeldung angeführtes Dokument
L : aus andern Gründen angeführtes Dokument
................................................................
& : Mitglied der gleichen Patentfamilie, übereinstimmendes
     Dokument

EPO FORM 1503 03.82 (P0403)